Europäisches Patentamt

(19) European Patent Office

Office Européen des brevets

(11) Publication number: **0 251 523 B1**

# EUROPEAN PATENT SPECIFICATION

(12)

(45) Date of publication of patent specification:
02.01.91 Bulletin 91/01

(51) Int. Cl.⁵: **H01L 21/90, H01L 23/52**

(21) Application number: **87305084.3**

(22) Date of filing: **09.06.87**

(54) **A method of producing a semiconductor device showing a good ohmic contact between a plurality of wiring layers.**

(30) Priority: **13.06.86 JP 137509/86**

(43) Date of publication of application:
**07.01.88 Bulletin 88/01**

(45) Publication of the grant of the patent:
**02.01.91 Bulletin 91/01**

(84) Designated Contracting States:
**DE FR GB**

(56) References cited:
**WO-A-81/00327
SOLID STATE TECHNOLOGY, vol. 29, no. 4,
April 1986, pages 129-134, Port Wahington,
New York, US; D.B. TUCKERMAN et al.:
"Laser planarization"
IBM JOURNAL OF RESEARCH &
DEVELOPMENT, vol. 25, no. 3, May 1981,
pages 107-115, Armonk, New York, US; J.C.
LOGUE et al.: "Techniques for improving
engineering productivity of VLSI designs"**

(56) References cited:
**APPLIED PHYSICS LETTERS, vol. 26, no. 3, 1st
February 1975, pages 124-126, American
Institute of Physics, New York, US; P.W. COOK
et al.: "Connections and disconnections on
integrated circuits using nanosecond laser
pulses"
SOLID STATE TECHNOLOGY, vol. 26, no. 12,
December 1983, pages 165-169, Port
Washington, New York, US; T. McGRATH:
"Applications of excimer lasers in
microelectronics"**

(73) Proprietor: **FUJITSU LIMITED
1015, Kamikodanaka Nakahara-ku
Kawasaki-shi Kanagawa 211 (JP)**

(72) Inventor: **Mukai, Ryoichi
Kopo Yoneyama 2F1 722, Shiboguchi
Takatsu-ku
Kawasaki-shi Kanagawa 213 (JP)**

(74) Representative: **Rackham, Stephen Neil et al
GILL JENNINGS & EVERY 53-64 Chancery
Lane
London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to a method of fabricating a semiconductor device. More particularly, the present invention relates to a method of establishing a good ohmic contact between a plurality of wiring layers composed of an Al film.

"Al film" as used herein refers to a film of aluminium or an aluminium alloy mainly composed of aluminium.

Conventionally a method of fabricating a semiconductor device to establish electrical contact between two wiring layers formed of aluminium or an aluminium alloy comprises forming a contact hole in an insulating film formed on a first wiring, covering the surface of the insulating film and the surface of the wiring exposed by the contact hole with a second wiring layer, and patterning the second wiring layer to form second wiring. However, upon exposure to air or an adsorbing material a layer of oxide or adsorbent is formed on the surface of the first wiring exposed by the contact hole. This forms an obstacle to the formation of a good ohmic contact between the two wiring layers. Previous attempts to remove this film have used ion bombardment by an Ar plasma as will be described in detail subsequently but these have not been completely satisfactory.

In "Laser Planarization", Solid State Technology, April 1986, pages 129-134, it is disclosed that a non-oxidising metal conductor film, such as of gold, is planarized by irradiation with a dye laser beam. For solving the problem of removal of an oxide or absorded film formed between two wiring layers of Al, sputter-etching of the native oxide or the absorded film prior to planarization is recommended instead.

The article "Techniques for Improving Engineering Productivity of VLSI Designs," IBM Journal of Research and Development, vol. 25, May 1981, pages 107-115, discloses connection of two Al layers separated by an insulating layer with the aid of a pulsed dye laser.

According to this invention such a fabrication method also includes a step in which laser beam pulses having an energy intensity between 5 and 12 J/cm$^2$ and a duration of less than 100 ns are applied to the second Al film wiring layer from above to remove an oxide or an adsorbed material formed on the first wiring and instantaneously to melt the second wiring so that it partially flows into the contact hole.

The present invention solves the problem of the conventional technique, and provides a method for fabricating a semiconductor device, in which a good ohmic contact can be obtained in a plurality of wiring layers without damaging an element.

A particular embodiment of a method in accordance with this invention will now be described and contrasted with the prior art with reference to the accompanying drawings, in which :-

Figure 1 is a sectional view illustrating a method for fabricating a semiconductor device according to one embodiment of the present invention ;
Figure 2 is a sectional view illustrating the conventional method for fabricating a semiconductor device ; and,
Figure 3 is a diagram showing experimental data, which illustrates effects attained in the embodiment of the present invention.

Figures 2a through 2C are sectional views illustrating the conventional method for fabricating a semiconductor device. As shown in Figure 2a an SiO$_2$ film 2 and an Al film 3 for a first wiring are formed on an Si substrate 1, and an SiO$_2$ film is formed as an interlaminar insulating film. A contact hole 5 is also formed.

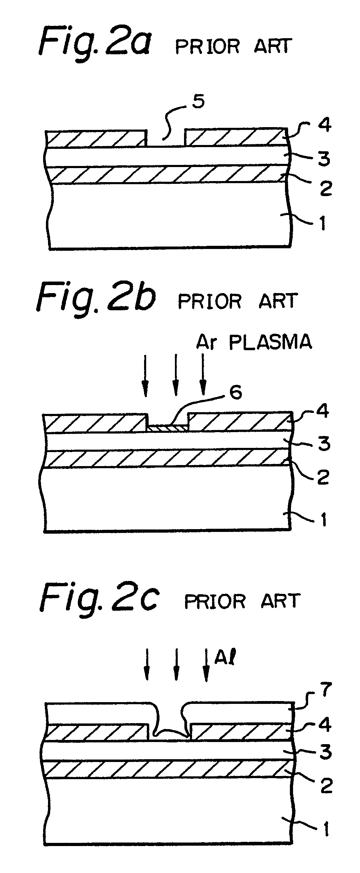

By formation of the contact hole 5, the Al film 3 is exposed and an oxide formed by reaction with O$_2$ in air or an adsorbed material 6 is deposited on the exposed surface of the Al film 3. The presence of the oxide or adsorbed material 6 is an obstacle to formation of a good ohmic contact. Therefore, according to the conventional technique, as shown in Figure 2b, the oxide or adsorbed material is removed by irradiation with Ar plasma before formation of an upper Al film.

Namely, as shown in Figure 2c, an Al film 7 is formed by the sputtering method and a good ohmic contact is obtained between the Al film 3 and the Al film 7.

As pointed out above, according to the conventional method, the oxide or adsorbed material 6 on the Al film 3 is removed by irradiation with Ar plasma before formation of the Al film 7.

However, according to the conventional method since irradiation with an ion or radical is carried out, the surface of the Al film 3 is roughened and the SiO$_2$ film 4 is seriously damaged, resulting in formation of a defective element. Especially, in a high-density MOSLSI, since a gate SiO$_2$ film is broken by the discharge of the electrical charge accumulated, a short circuit is readily formed. Further, where the contact hole 5 has a very small diameter or a very large depth, it is difficult to satisfactorily remove the oxide or adsorbed material 6 due to the insufficient irradiation of the Ar plasma, or to obtain a good contact between the Al films 3 and 7 due to the insufficient penetration of Al into the hole. Therefore, the development of a means for overcoming these disadvantages is eagerly desired.

The method for fabricating a semiconductor device according to the present invention is characterized by the steps of forming a contact hole in an insulating film formed on a first wiring composed of an Al film, covering the insulating film with an Al film for a second wiring, applying laser beam pulses to the Al film for a second wiring from above, and patterning the Al film to form a second wiring.

According to the present invention, after formation of the Al film for a second wiring, laser beam pulses are applied to the Al film from above, whereby the oxide or adsorbed material formed on the Al film for a first wiring is removed and a good ohmic contact is obtained between the Al film for a first wiring and the Al film for a second wiring. By irradiation with these pulses, the upper Al film is appropriately instantaneously melted and flows into the contact hole, and therefore, a good coverage with the Al film can be attained at the step portion and disconnection can be prevented.

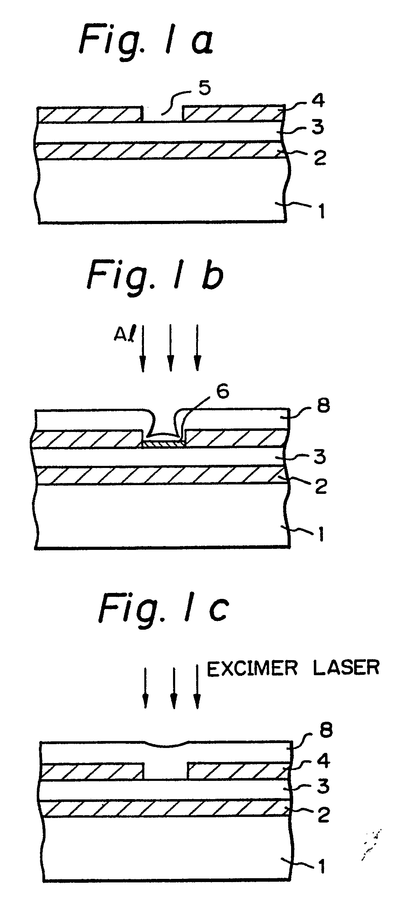

An embodiment of the present invention will now be described with reference to the accompanying drawings. Figures 1a through 1c are diagrams illustrating a method for fabricating a semiconductor device according to the embodiment of the present invention. Note, the same reference numerals as in Figure 2 represent the same members.

(1) Referring to Fig. 1a, an $SiO_2$ film formed on an Si substrate 1. Reference numeral 3 represents an Al film as a first wiring, reference numeral 4 represents an $SiO_2$ film formed as an interlaminar insulating film on the Al film 3, and reference numeral 5 represents a contact hole.

(2) Then, as shown in Fig. 1b, an Al film 8 is covered on the entire surface by, for example, the sputtering method. Since an oxide or adsorbed material 6 is formed on the surface of the Al film 3 exposed by formation of the contact hole, the contact between the Al films 8 and 3 is not always good. Furthermore, the coverage with the Al film 8 at the step portion of the insulating film 4 in the contact hole is not sufficient.

(3) Then, as shown in Fig. 1c, excimer laser beam pulses are applied to the Al film 8 from above. For example, ArF excimer laser beam (wavelength = 193 nm) is used as the excimer laser beam, and the irradiation is carried out under conditions of an energy intensity of 10 $J/cm^2$ and a pulse width of 15 ns. If the energy intensity is lower than 3 $J/cm^2$, a substantial effect is not attained. In contrast, if the energy intensity is higher than 15 $J/cm^2$, the Al film is damaged. Accordingly, preferably the energy intensity is 5 to 12 $J/cm^2$. Furthermore, if the pulse width is increased (for example, to 1 μs) or continuous waves are applied, the Al film 8 is damaged and good results can not be obtained. Note, the $KrF_2$ excimer laser beam (wavelength = 248 nm), XeCl excimer laser beam (wavelength = 308 nm) and TEA-$CO_2$ laser beam (wavelength = 106 nm) can be also used as the laser beam. These laser beams may preferably have a pulse width of not larger than 100 ns.

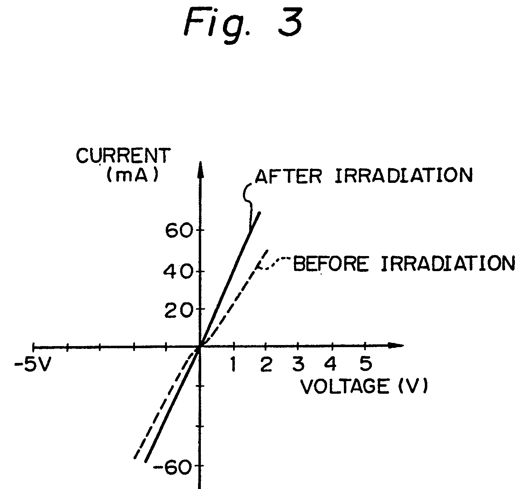

By this irradiation with laser beam, a good ohmic contact can be obtained between the Al film 3 and Al film 8. This is illustrated in Fig. 3, which is a diagram showing experimental data. From Fig. 3, it is seen that, by irradiation with laser beam, a good ohmic contact is obtained between the upper Al film and the lower Al film.

Moreover, since by irradiation with laser beam pulses, the Al film 8 is appropriately melted without being damaged and the melt flows into the contact hole 5, the coverage with the Al film 8 at the step portion of the insulating film 4 is greatly improved.

As is apparent from the foregoing illustration, by irradiation with laser beam pulses, a good ohmic contact can be obtained in a plurality of wiring layers composed of an Al film without damaging the Al film. Accordingly, a semiconductor device having a high quality and a high integration degree can be provided.

Moreover, since the Al film is appropriately melted by irradiation with laser beam and the melt flows into the contact hole, the coverage with the Al film at the step portion can be improved and disconnection can be prevented.

## Claims

1. A method of fabricating a semiconductor device to establish electrical contact between two wiring layers (3, 8) formed of aluminium or an aluminium alloy comprises forming a contact hole (5) in an insulating film (4) formed on a first wiring (3), covering the surface of the insulating film (4) and the surface of the wiring (3) exposed by the contact hole (5) with a second wiring layer (8), and patterning the second wiring layer to form a second wirin, characterised in that laser beam pulses having an energy intensity between 5 and 12 $J/cm^2$ and a duration of less than 100 ns are applied to the second wiring layer (8) from above to remove an oxide or an adsorbed material (6) formed on the first wiring (3) and instantaneously to melt the second wiring (8) that it partially flows into the contact hole (5).

2. A method according to claim 1, wherein the pulsed laser beam is selected from ArF excimer laser beam, $KrF_2$ excimer laser beam, XeCl excimer laser beam and TEA-$CO_2$ laser beam.

3. A method according to claim 1 or 2, wherein the duration of the laser pulses is substantially 15 ns.

## Ansprüche

1. Verfahren zur Fabrikation einer Halbleitervorrichtung, um einen elektrischen Kontakt zwischen zwei Verdrahtungsschichten (3, 8) herzustellen, die aus Aluminium oder einer Aluminiumlegierung geildet sind, mit Bilden eines Kontaktloches (5) in einem isolierenden Film (4), der auf einer ersten Verdrahtung (3) gebildet ist, Bedecken der Oberfläche des isolierenden Films (4) und der Oberfläche der Verdrahtung (3), die durch das Kontaktloch (5) exponiert ist, mit einer zweiten Verdrahtungsschicht (8), und Mustern der genannten zweiten Verdrahtungsschicht, um eine zweite Verdrahtung zu bilden,

dadurch gekennzeichnet, daß Laserstrahlimpulse mit einer Energieintesität zwischen 5 und 12 J/cm und einer Dauer von weniger als 100 ns von oben auf die zweite Verdrahtungsschicht aufgebracht wird, um ein Oxid oder ein adsobiertes Material (6) zu entfernen, das auf der ersten Verdrahtungsschicht (3) gebildet ist, und um augenblicklich die zweite Verdrahtung (8) zu schmelzen, so daß sie teilweise in das Kontaktloch (5) fließt.

2. Verfahren nach Anspruch 1, bei dem der gepulste Laserstrahl ausgewählt ist aus einem ArF-Excimerlaserstrahl, $KrF_2$-Excimerlasestrahl, XeCl-Excimerlaserstrahl und TEA-$Co_2$-Laserstrahl.

3. Verfahren nach Ansprpuch 1 oder 2, bei dem die Dauer der Laserimpulse im wesentlichen 15 ns beträgt.

## Revendications

1. Un procédé de fabrication d'un dispositif à semiconducteur pour établir le contact électrique entre deux couches de câblage (3, 8) formées d'aluminium ou d'un alliage d'aluminium, ledit procédé comprenant la formation d'un trou de contact (5) dans un film isolant (4) formé sur un premier câblage (3), le recouvrement de la surface du film isolant (4) et de la surface du câblage (3) exposée par le trou de contact (5) par une seconde couche de câblage (8), et la formation d'un motif sur la seconde couche de câblage pour former un second câblage,

caractérisé en ce que des impulsions de faisceau laser ayant une intensité d'énergie comprise entre 5 et 12 $J/cm^2$ et une durée inférieure à 100 ns sont appliquées à la seconde couche de câblage (8) à partir du dessus pour enlever un oxyde ou un matériau adsorbé (6) formé sur le premier câblage (3) et pour fondre instantanément le second câblage (8) de sorte qu'il s'écoule partiellement à l'intérieur du trou de contact (5).

2. Un procédé selon la revendication 1, selon lequel le faisceau laser à impulsions est choisi parmi les suivants : faisceau laser à excimère ArF, faisceau laser à excimère $KrF_2$, faisceau laser à excimère XeCl et faisceau laser à TEA-$CO_2$ .

3. Un procédé selon la revendication 1 ou 2, selon lequel la durée des impulsions de laser est substantiellement de 15 ns.

# Fig. I a

# Fig. I b

Aℓ

# Fig. I c

EXCIMER LASER

*Fig.2a* PRIOR ART

*Fig.2b* PRIOR ART

Ar PLASMA

*Fig.2c* PRIOR ART

Aℓ

# Fig. 3